# EUROPEAN PATENT APPLICATION

(11) **EP 2 535 441 A1**
(43) Date of publication of application: **19.12.2012**
(21) Application number: 11169738.9
(22) Date of filing: 14.06.2011
(51) Int. Cl.: C23C 18/16, C23C 18/31, C23C 18/32, H01L 23/532, H01L 21/768

(54) **Copper filled opening with a cap layer**

(71) Applicant: Atotech Deutschland GmbH, 10553 Berlin (DE)
(72) Inventor: Rohde, Dr. Dirk, 10553 Berlin (DE); Dambrowsky, Dr. Nina, 10555 Berlin (DE); Gaida, Josef, 10715 Berlin (DE); Uhlig, Dr. Albrecht, 12524 Berlin (DE); van den Boom, Ruud, Albany NY, 12208 (US)
(74) Representative: Wonnemann, Jörg

(57) **Abstract**

The invention concerns openings in substrates filled with a copper deposit. Thermal annealing processes lead to an irreversible expansion of said copper deposit and hence to the formation of voids in the copper deposit and cracks between the surface of the substrate and active or passive overlying structures. The present invention provides cap layers which suppress the irreversible expansion of copper during or after thermal annealing.

## Description

### Field of the Invention

The present invention relates to cap layers for copper filled openings in a substrate.

### Background of the Invention

Electronic devices made of a substrate material selected from silicon, glass and ceramics comprise openings filled with copper.

An opening formed in silicon substrates is denoted herein a through-silicon via (TSV).

An opening formed in glass substrates is denoted herein a through-glass via (TGV).

An opening formed in ceramic substrates is denoted herein a through-ceramic via (TCV).

The surface of the opening is activated for electroplating of copper. Typical activation procedures comprise activation by means of noble metal ions followed by reduction or by deposition of colloidal particles of a noble metal. The most common noble metal for said purpose is palladium.

Another common method is to deposit a seed layer consisting of copper by PVD or CVD or ALD.

The opening is then filled with copper by electroplating. Copper plating bath compositions and methods for filling of such openings are disclosed for example in US 6,800,188 B2 and US 2010/0041226 A1. After via filling, the opening bears a copper surface on one side or on both sides of the substrate depending on the overall manufacturing process for the electronic device applied.

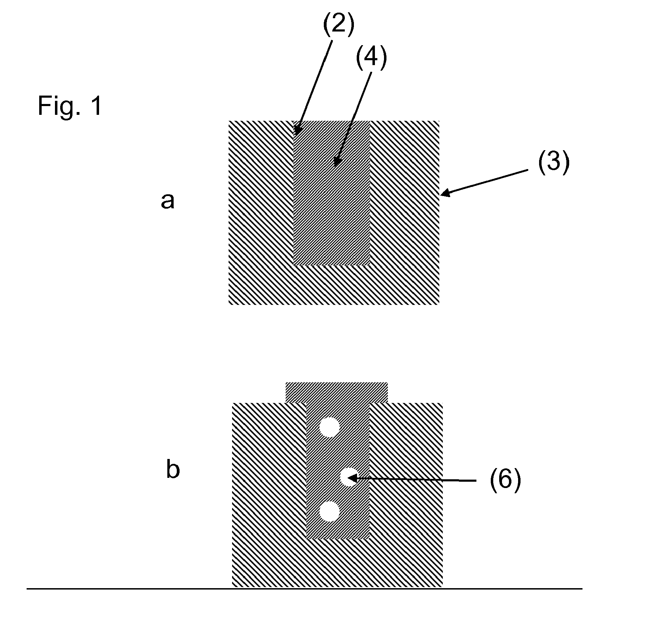

In order to obtain a copper filled opening a certain amount of copper is deposited on top or the substrate. This overplated copper is removed for example by one of the methods including chemical mechanical polishing (CMP), wet chemical etching, dry etching or a combination of the aforementioned (Figs. 1 a, 2 a and 3 a). The CMP process is disclosed for example in "Chemical Mechanical Planarization", SIMTech Technical Report (PT/01/003/JT). Wet chemical methods for etching of copper are disclosed in "Printed Circuits Handbook", C. F. Coombs, Jr. (Ed.), 5th Edition, pp. 33.4-33.18.

In case the opening is a TSV, at least one overlying active or passive structure such as a redistribution layer (RDL) built-up or a contact area is manufactured on top of the surface of the silicon or glass substrate.

A RDL relocates bond pads from the outer surface of a microchip to the interconnects inside a microchip. Such a RDL comprises copper tracks and a dielectric material.

A contact area comprises a solderable and/or bondable surface of one or more metal layers selected from copper, nickel, palladium, gold, tin, silver and alloys thereof on top of the copper filled TSV.

The copper deposit in the opening is thermally annealed at a temperature in the range of 100 to 450 °C, preferably 300 to 450 °C for 1-100 min in order to release stress from the electroplated copper deposit. Said thermal annealing process step is associated with an irreversible diffusion of copper atoms in the electroplated copper deposit along grain boundaries to the surface of the copper deposit.

This effect is called protrusion and comprises diffusion of copper atoms to the one or two open side(s) of the copper filled opening and leads at the same time to the formation of voids in said copper filled opening. This is shown for a TSV having on open side in Fig. 1. The voids are not closed after the thermal annealing process because protrusion is an irreversible process.

Furthermore, cracks occur between the surface of the substrate and the overlying active or passive structures in case of a copper filled opening.

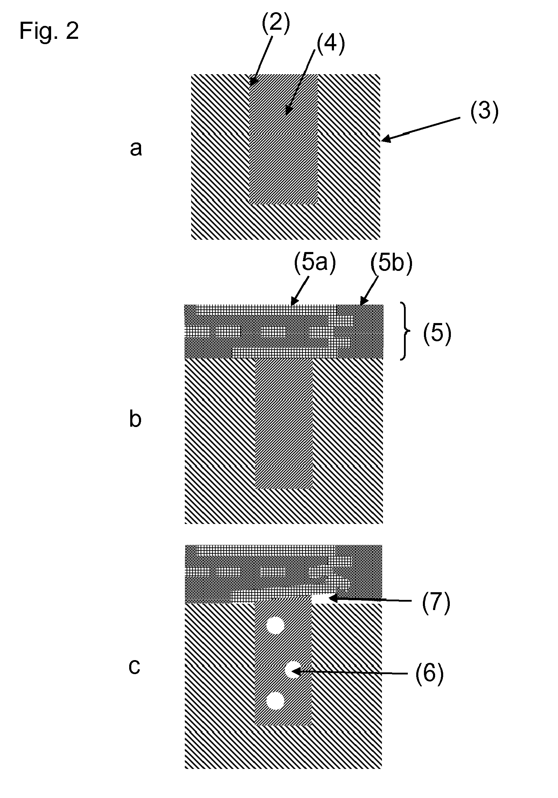

This is shown for a RDL built-up as the overlying structure on top of a silicon substrate in Fig. 2 .

### Objective of the present Invention

Therefore it is the objective of the present invention to provide a method which reduces the formation of voids in the copper deposit in an opening and avoids the formation of cracks between the surface of the substrate and the overlying active or passive structures during or after thermal annealing of said copper deposit.

### Summary of the Invention

These objectives are solved by applying a cap layer which is deposited on top of the one or two openings of a copper filled opening after planarisation of the copper deposited into the opening.

Said cap layer suppresses irreversible diffusion of copper atoms to the one or two open side(s) of the opening during thermal annealing and thereby reduces the formation of voids in the copper deposit.

Furthermore, no cracks are formed between an overlying active or passive structure and the planarised electroplated copper and/or the surface of the substrate during or after thermal annealing.

### Brief Description of the Figures

Fig. 1 shows a via filled with copper prior (a) and after thermal annealing (b) according to the prior art.
Fig. 2 shows a method for manufacture of a RDL built-up on a copper filled TSV and a substrate surface according to the prior art.
Fig. 3 shows a via filled with copper having a cap layer on top prior (a) and after thermal annealing (b) according to the present invention.
Fig. 4 shows a method according to the present invention wherein the cap layer is not removed prior to manufacture of the RDL built-up.
Fig. 5 shows a method according to the present invention wherein the cap layer is removed before manufacture of the RDL built-up.

### Detailed Description of the Invention

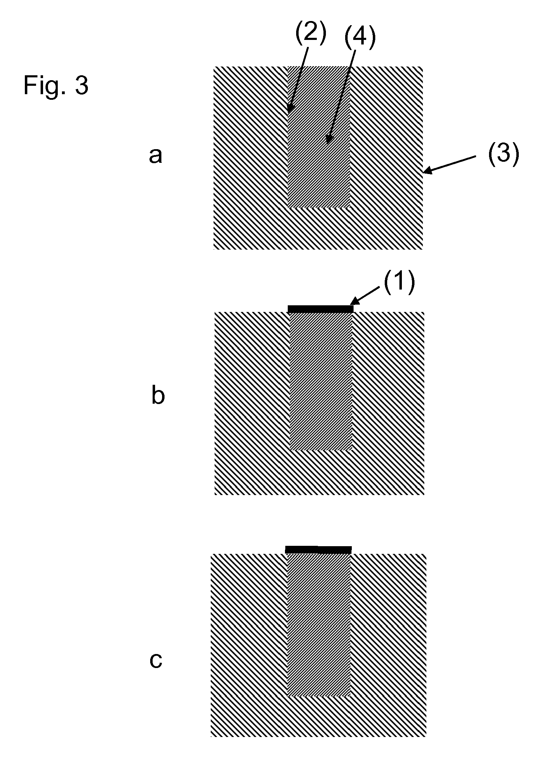

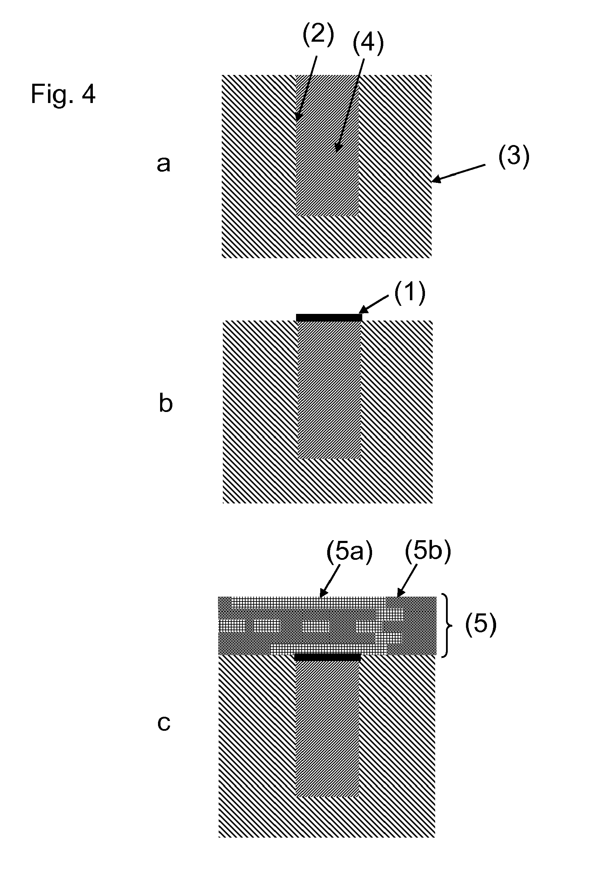

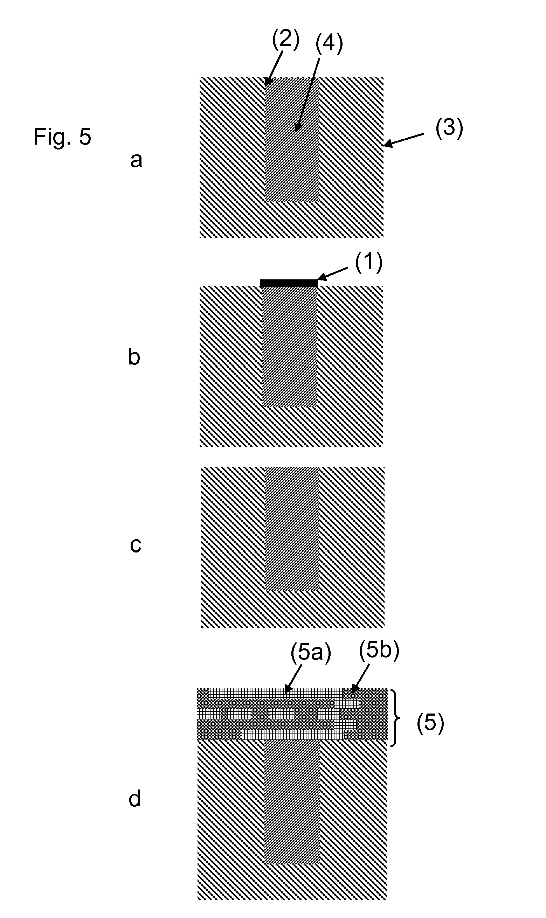

An opening (2) in a substrate (3) filled with a copper deposit (4) after the planarisation process step is provided (Fig. 3 a, Fig. 4 a and Fig. 4 a). The planarised copper deposit (4) is cleaned and a cap layer (1) is deposited onto the cleaned copper surface (Fig. 3 b, Fig. 4 b and Fig. 5 b). When subjecting the substrate to a thermal annealing step, formation of voids in the copper deposit and diffusion of copper in direction of the open side of the via are suppressed (Fig.3c).

In one embodiment of the present invention, the planarised and cleaned surface of the copper deposit (4) is activated before electroless deposition of a cap layer e.g. by immersion of the substrate in a Pd²⁺ ions containing solution (1).

The cap layer (1) is then deposited by a vapour deposition method such as physical vapour deposition (PVD), chemical vapour deposition (CVD) and atomic layer deposition (ALD) or by electroless plating.

The preferred deposition method for deposition of the cap layer (1) is electroless plating.

In case the cap layer (1) is deposited by a vapour deposition method an etching procedure following the deposition of the cap layer material is required. Both wet chemical etching and dry etching by e.g. plasma etching or a combination of wet chemical and dry etching can be applied for said purpose.

Suitable compositions for wet chemical etching comprise H₂0₂ or a peroxide salt.

The etching procedure is required when the cap layer material is deposited by a vapour deposition method, it then covers the whole surface of the substrate and provides an electrical contact over the whole substrate surface which is not acceptable. Hence, all deposited cap layer material deposited in between the planarised copper deposit must be removed.

In case the cap layer (1) is deposited by electroless plating no etching procedure is required because the cap layer material is selectively deposited onto the copper deposit (4) in the through-hole (2).

The cap layer (1) material is selected from the group comprising Ta, Mo, W, Ti-W alloys, Ta-W alloys, Ti-N alloys, Ta-N alloys, W-N alloys, Ni-B alloys, Ni-P alloys, Ni-M-P alloys, Ni-M-B alloys, Ni-M-P-B alloys, Co-P alloys, Co-B alloys, Co-P-B alloys, Co-M-P alloys, Co-M-B alloys and Co-M-P-B alloys wherein M is selected from the group consisting of Mn, Zr, Mo, Ta and W.

The preferred cap layer (1) material is selected from the group consisting of Ni-B alloys, Ni-P alloys, Ni-M-P alloys, Ni-M-B alloys, Ni-M-P-B alloys, Co-P alloys, Co-B alloys, Co-P-B alloys, Co-M-P alloys, Co-M-B alloys and Co-M-P-B alloys wherein M is selected from the group consisting of Mn, Zr, Re, Mo, Ta and W.

The most preferred cap layer (1) material is selected from the group consisting of Co-M-P alloys, Co-M-B alloys and Co-M-P-B alloys wherein M is Mo or W.

The thickness of the cap layer (1) ranges from 50 to 1500 nm, more preferably from 100 to 1000 nm.

Plating bath compositions for electroless plating of the aforementioned Ni and Co alloys comprise a Ni ion or Co ion source, a reducing agent such as Na-hypophosphite and/or borohydride, at least one complexing agent and at least one stabilizing agent.

Applicable for deposition of a cap layer (1) by electroless plating are aqueous Ni and Co alloy plating solutions comprising a Ni or Co salt, and a reducing agent such as hypophosphorous acid or a bath soluble salt thereof. Preferably, the hypophosphite reducing agent is selected from sodium hypophosphite, potassium hypophosphite and ammonium hypophosphite. This solution should preferably be free of alkali or alkaline earth metal ions which may form an insoluble orthophosphite.

Optionally, the plating bath further contains a source of M-ions. Suitable sources of M-ions are selected from the group comprising water soluble compounds providing Mn, Zr, Re, Mo, Ta and W. The preferred sources of M-ions are molybdates and wolframates such as Na₂Mo0₄ and Na₂WO₄. The amount of M-ions added to the plating bath ranges from 5 to 20 g/I, more preferably from 8 to 12 g/I. The amount of M-ions in the plating bath must be sufficient to reach a concentration of 2 to 7 wt.-% M in the cap layer (1).

In the electroless Ni and Co alloy solutions the operating Ni or Co ion concentration is typically from 1 to 18 g/I, preferably 3 to 9 g/I are utilised.

The amount of the reducing agent employed in the plating bath ranges from 2 to 60 g/I, more preferably from 12 to 50 g/I and most preferably from 20 to 45 g/I. As a conventional practice the reducing agent is replenished during the reaction.

The complexing agents are employed in amounts of up to 200 g/I, more preferably from 15 to 75 g/l.

In one embodiment, carboxylic acids, polyamines or sulfonic acids or mixtures thereof are selected as complexing agents. Useful carboxylic acids include the mono-, di-, tri- and tetra-carboxylic acids. The carboxylic acids may be substituted with various substituent moieties such as hydroxy or amino groups and the acids may be introduced into the plating solutions as their sodium, potassium or ammonium salts. Some complexing agents such as acetic acid, for example, may also act as a buffering agent, and the appropriate concentration of such additive components can be optimised for any plating solution in consideration of their dual functionality.

Examples of such carboxylic acids which are useful as the complexing agents include: monocarboxylic acids such as acetic acid, hydroxyacetic acid (glycolic acid), aminoacetic acid (glycine), 2-amino propanoic acid, (alanine); 2-hydroxy propanoic acid (lactic acid); dicarboxylic acids such as succinic acid, amino succinic acid (aspartic acid), hydroxy succinic acid (malic acid), propanedioic acid (malonic acid), tartaric acid; tricarboxylic acids such as 2-hydroxy-1,2,3 propane tricarboxylic acid (citric acid); and tetracarboxylic acids such as ethylene diamine tetra acetic acid (EDTA). In one embodiment, mixtures of 2 or more of the above complexing agents are utilised.

The aqueous electroless plating baths can be operated over the above mentioned pH range. Since the plating solution has a tendency to become more acidic during its operation due to the formation of hydrogen ions, the pH may be periodically or continuously adjusted by adding bath-soluble and bath-compatible alkaline substances such as sodium, potassium or ammonium hydroxides, carbonates and bicarbonates. The stability of the operating pH of the plating solutions can be improved by the addition of various buffer compounds such as acetic acid, propionic acid, boric acid, or the like, in amounts of up to 30 g/l, more preferably from 2 to 10 g/l.

The electroless plating solutions also include organic and/or inorganic stabilising agents of the types heretofore known in the art including lead ions, cadmium ions, tin ions, bismuth ions, antimony ions and zinc ions which can be conveniently introduced in the form of bath soluble and compatible salts such as the acetates, etc. Organic stabilisers useful in electroless plating solutions include sulfur-containing compounds such as, for example, thiourea, mercaptans, sulfonates, thiocyanates, etc. The stabilisers are used in small amounts such as from 0.05 to 5 ppm of solution, and more preferably in amounts of 0.1 to 2 or 3 ppm.

The substrate to be plated is contacted with the plating solution at a temperature of at least 40°C up to the boiling point of the solution. Electroless plating baths of an acidic type are employed, in one embodiment, at a temperature of from 70°C to 95 °C, and more preferably, at a temperature of from 80°C to 90 °C. Electroless plating baths on the alkaline side generally are operated within the broad operating range but generally at a lower temperature than the acidic electroless plating solutions.

The duration of contact of the electroless plating solution with the substrate being plated is a function which is dependent on the desired thickness of the deposited Ni or Co alloy. Typically, the contact time can range from 2 to 10 min.

During the deposition of the Ni or Co alloy, mild agitation generally is employed, and this agitation may be a mild air agitation, mechanical agitation, bath circulation by pumping, rotation of the substrate to be plated, etc. The plating solution may also be subjected to a periodic or continuous filtration treatment to reduce the level of contaminants therein. Replenishment of the constituents of the bath may also be performed, in some embodiments, on a periodic or continuous basis to maintain the concentration of constituents, and in particular, the concentration of nickel ions and hypophosphite ions, as well as the pH level within the desired limits.

The substrate is then rinsed, preferably with water.

In one embodiment of the present invention the cap layer (1) is not removed prior to manufacture of the overlying active or passive structure. Instead, for example a RDL built-up (5) is manufactured on top of the cap layer (1) and the surface of the substrate (3) (Fig. 2 c). The copper deposit (4) is then thermally annealed at a temperature in the range of 100 to 450 °C for 1 to 100 min

In another embodiment of the present invention the cap layer (1) is removed after thermal annealing and prior to manufacturing the overlying active or passive structure (Fig. 3 c).

The cap layer (1) can be removed by wet chemical etching, dry etching, plasma etching, by CMP or a combination of the aforementioned methods.

Suitable etching solutions for cap layer materials are known in the art:
Ti-W alloys, Ta-W alloys, Ti-N alloys and Ti-N alloys can be removed e.g. by plasma etching e.g. SF₆/Ar, HBr/O₂, and Cl₂/O₂ plasmas.
Ni-B alloys, Ni-P alloys, Ni-M-P alloys, Ni-M-B alloys, Ni-M-P-B alloys, Co-P alloys, Co-B alloys, Co-P-B alloys, Co-M-P alloys, Co-M-B alloys and Co-M-P-B alloys wherein M is selected from the group consisting of Mn, Zr, Re, Mo, Ta and W can be removed by contacting the substrate with nitric acid or by means of a plasma,

An overlying active or passive structure is then manufactured. For example, a RDL built-up (5) is then manufactured on top of the planarised and thermally annealed copper deposit (4) and the surface of the silicon substrate (3) by methods known in the art (Figs. 2 c and 3 d). Such a RDL built-up (5) comprises copper tracks (5a) and dielectric material (5b). Benzocyclobutene and Polyimide are typically used as the dielectric material (5b).

In still another embodiment of the present invention the cap layer (1) is removed after thermal annealing the copper deposit. No overlying active or passive structures are manufactured afterwards. Instead, at least two of such substrates are bonded together via the surfaces of the copper filled openings by copper diffusion bonding.

The following examples further illustrate the present invention.

### Examples

Silicon substrates having TSVs were subjected to electroplating of copper followed by planarising the copper filled TSVs afterwards.

### Example 1 (comparative)

A silicon substrate having copper filled TSVs and no cap layer (1) deposited onto the planarised copper deposit was subjected to a thermal annealing at 450 °C for 30 min.

The SEM micrograph of a cross-section prepared after thermal annealing shows protrusion of copper on the open side of the copper filled TSVs (Fig. 1 b).

### Example 2

A cap layer (1) consisting of a CoWP alloy with an average thickness of 0.8 µm was deposited by electroless plating on top of the planarised copper deposits of a substrate according to example 1. Next, said substrate was subjected to a thermal annealing (450 °C, 30 min).

The SEM micrograph of a cross-section prepared after thermal annealing shows no protrusion of copper on the open side of the copper filled TSVs (Fig. 3 c).

## Claims

1. Use of a cap layer (1) on top of an electroplated copper deposit in a via to suppress protrusion of said copper deposit
wherein the cap layer (1) consists of a metal or metal alloy selected from the group consisting of Ta, Mo, W, Ti-W alloys, Ta-W alloys, Ti-N alloys, Ta-N alloys, W-N alloys, Ni-B alloys, Ni-P alloys, Ni-M-P alloys, Ni-M-B alloys, Ni-M-P-B alloys, Co-P alloys, Co-B alloys, CoP-B alloys, Co-M-P alloys, Co-M-B alloys and Co-M-P-B alloys wherein M is selected from the group consisting of Mn, Zr, Re, Mo, Ta and W.

2. Use of a cap layer (1) according to claim 1 wherein the cap layer (1) consists of a metal alloy selected from the group consisting of Ni-B alloys, Ni-P alloys, Ni-M-P alloys, Ni-M-B alloys, Ni-M-P-B alloys, Co-P alloys, Co-B alloys, Co-P-B alloys, Co-M-P alloys, Co-M-B alloys and Co-M-P-B alloys wherein M is selected from the group consisting of Mn, Zr, Re, Mo, Ta and W.

3. Use of a cap layer (1) according to any of the foregoing claims wherein the cap layer (1) consists of a metal alloy selected from the group consisting of Co-M-P alloys, Co-M-B alloys and Co-M-P-B alloys wherein M is selected from the group consisting of Mo and W.

4. Use of a cap layer (1) according to any of the foregoing claims wherein the cap layer (1) is deposited by electroless plating.

5. Use of a cap layer (1) according to any of the foregoing claims wherein the cap layer (1) has a thickness in the range of 50 to 1500 nm.
